# EUROPÄISCHE PATENTSCHRIFT

(11) **EP 0 570 447 B1**
(45) Veröffentlichungstag und Bekanntmachung des Hinweises auf die Patenterteilung: **23.09.1998**
(21) Anmeldenummer: 92904270.3
(22) Anmeldetag: 27.01.1992
(51) Int. Cl.: H01L 29/732, H01L 29/10, H01L 21/331

(54) **Verfahren zur Herstellung eines Bipolartransistors**
Method of making a bipolar transistor
Méthode de fabrication d'un transistor bipolaire

(30) Priorität: 08.02.1991 DE 4103898
(43) Veröffentlichungstag der Anmeldung: 24.11.1993
(73) Patentinhaber: SIEMENS AKTIENGESELLSCHAFT, 80333 München (DE)
(72) Erfinder: KLOSE, Helmut, D-81929 München (DE)
(86) Internationale Anmeldenummer: DE9200045
(87) Internationale Veröffentlichungsnummer: WO9214267

(56) Entgegenhaltungen:
- EP-A- 170 250
- EP-A- 409 370
- GB-A- 2 081 507
- Patents Abstracts of Japan, Bd. 13, Nr. 386 (E-812), 25. August 1989, & JP-A-1 134 970

## Beschreibung

Zur Erhöhung der Packungsdichte in integrierten Schaltungen werden zunehmend sogenannten oxidrandbegrenzte Bipolartransistoren eingesetzt. Als oxidrandbegrenzter Bipolartransistor wird ein Bipolartransistor bezeichnet, dessen Emitter und Basis mindestens an einer Seite durch einen Oxidrand begrenzt ist. Diese Bipolartransistoren weisen niedrigere Kapazitäten auf.

Zur Herstellung wird auf einem Substrat der Oxidrand erzeugt. Nach Bildung der Basis durch Ionenimplantation wird auf der Oberfläche des Substrats und des Oxidrands eine dotierte Polysiliziumschicht erzeugt, aus der der Emitter durch Ausdiffusion hergestellt wird. Vor Abscheidung der Polysiliziumschicht muß die Oberfläche des Substrats z.B. durch einen HF-Dip vorbehandelt werden. Dabei kommt es zu einer Dünnung der Basis an der Oxidkante. Dies führt insbesondere bei sehr flachen Emitter-Basis-Profilen im fertigen Bipolartransistor zu reduzierten Emitter-Kollektor-Ausbeuten und- Durchbruchsspannungen.

Aus JP-A-1 134 970 ist bekannt, zur Bildung eines Basisrandgebietes in einem oxidrandbegrenzten Bipolartransistor auf ein Substrat, das einen vergrabenen Kollektor sowie Feldoxidbereiche umfaßt, eine dotierte Spin-off-Glasschicht abzuscheiden. Durch Ausdiffusion aus dieser Schicht werden gleichzeitig Basisrandgebiete und eine aktive Basis gebildet.

Der Erfindung liegt das Problem zugrunde, ein Verfahren zur Herstellung einer solchen Bipolartransistorstruktur anzugeben, wodurch die Basisrandgebiete mit einer Tiefe und Dotierung hergestellt werden können, die unabhängig von der aktiven Basis eingestellt werden können.

Das Problem wird erfindungsgemäß gelöst durch ein Verfahren zu deren Herstellung nach Anspruch 1.

In der so hergestellten Bipolartransistorstruktur wird durch Einführung eines Basisrandgebietes, das hoher dotiert ist als der übrige Teil der Basis und das an dem dem Isolationsbereich benachbarten Rand der Basis angeordnet ist, die Emitter-Kollektor Spannungsfestigkeit und -Ausbeute deutlich erhöht.

Es liegt im Rahmen der Erfindung, daß der Isolationsbereich einen ersten Bestandteil und einen zweiten Bestandteil enthält. Der erste Bestandteil überragt in der Höhe die Höhe der Oberfläche des Substrats im Bereich des Emitters und weist eine dem Emitter und der Basis zugewandte Flanke auf, die nicht parallel zur Oberfläche des Substrats verläuft. Dieser erste Bestandteil des Isolationsbereichs wird z. B. in einem LOCOS-Prozeß, insbesondere in dem Coplanar-Prozeß, erzeugt.

An der Flanke des ersten Bestandteils ist als Flankenbedeckung (Spacer) der zweite Bestandteil angeordnet. Die Flankenbedeckung ist oberhalb des Basisrandgebietes angeordnet. Sie besteht aus einem dotierten Isolationsmaterial, so daß sie als Diffusionsquelle zur Bildung des Basisrandgebietes geeignet ist. Das dotierte Isolationsmaterial besteht aus Bor-Silikat-Glas. Das Basisrandgebiet wird selbstjustiert zu dem Isolationsbereich am Rand der Basis gebildet, da die Flankenbedeckung mit Hilfe einer Spacertechnik selbstjustiert an der Flanke des ersten Bestandteils des Isolationsbereichs herstellbar ist.

Bei der Herstellung der Bipolartransistorstruktur kommt es bei der Oberflächenbehandlung vor der Abscheidung einer dotierten polykristallinen Siliziumschicht zur Erzeugung des Emitteranschlusses zwar auch zu einem Abtrag an der freiliegenden Oberfläche, da jedoch die Basis am Rand durch das Basisrandgebiet verstärkt ist, wird eine Dünnung der Basis und damit eine Schwachstelle für die Emitter-Kollektor-Spannungsfestigkeit vermieden.

Weitere Ausgestaltungen der Erfindung gehen aus den übrigen Ansprüchen hervor.

Im folgenden wird die Erfindung anhand eines Ausführungsbeispiels und der Figuren näher erläutert.
- Fig. 1 bis Fig. 4: zeigen Herstellungsschritte für eine Bipolartransistorstruktur, deren Basis-Emitter-Struktur an gegenüberliegenden Seiten durch einen Oxidrand begrenzt ist.
- Fig. 5: zeigt die fertige Bipolartransistorstruktur.
- Fig. 6: zeigt den in Fig. 5 mit VI-VI bezeichneten Schnitt durch die Bipolartransistorstruktur.
- Fig. 7: zeigt einen Schnitt durch einen Außenspacer-Transistor.

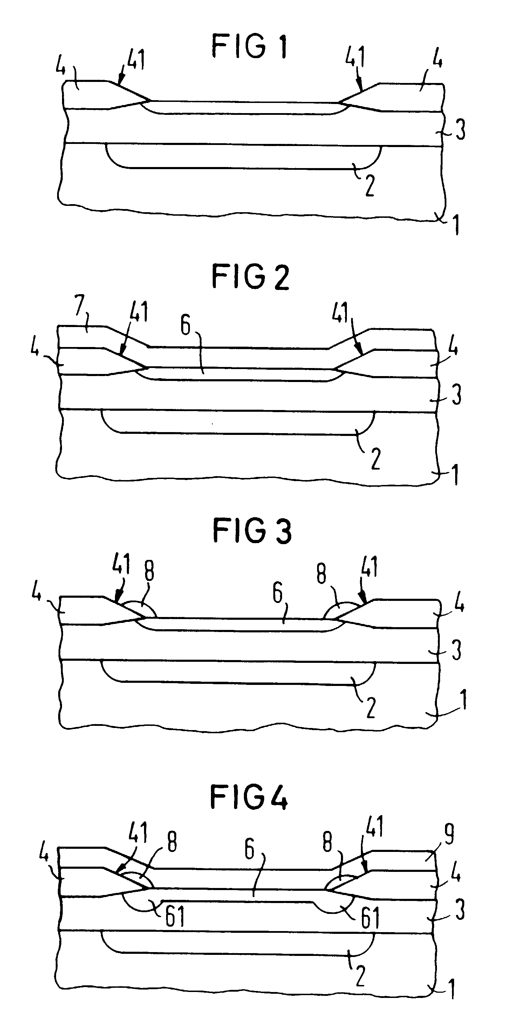

In einem Substrat 1 aus Silizium, das z. B. p-dotiert ist, wird nach entsprechender Maskierung durch Ionenimplantaticn mit z. B. Arsen oder Antimon eine vergrabene Kollektorschicht 2 erzeugt (s. Fig. 1).

Auf die Oberfläche des Substrats mit der vergrabenen Kollektorschicht 2 wird eine n-dotierte Epitaxieschicht 3 abgeschieden. Die Epitaxieschicht 3 weist einen spezifischen widerstand von z. B. 1 Ohm x cm auf.

Anschließend werden Isolationsstrukturen 4 in einem lokalen Oxidationsprozeß gebildet. Dazu ist z. B. der sogenannte Koplanarprozeß geeignet, der eine Variante des bekannten LOCOS-Prozeß darstellt. In dem Koplanarprozeß wird zwischen den im LOCOS-Prozeß verwendeten Oxid- und Nitridschichten eine zusätzliche Polysiliziumschicht eingeführt. Die Isolationsstruktur 4 begrenzt an zwei gegenüberliegenden Seiten denjenigen Bereich der Oberfläche der Epitaxieschicht 3, in dem später Emitter und Basis hergestellt werden. Die Isolationsstruktur 4 überragt in ihrer Höhe die Oberfläche des freiliegenden Siliziums. Die Isolationsstruktur 4 weist Flanken 41 auf, die auf die freiliegende Oberfläche des Siliziums zulaufen.

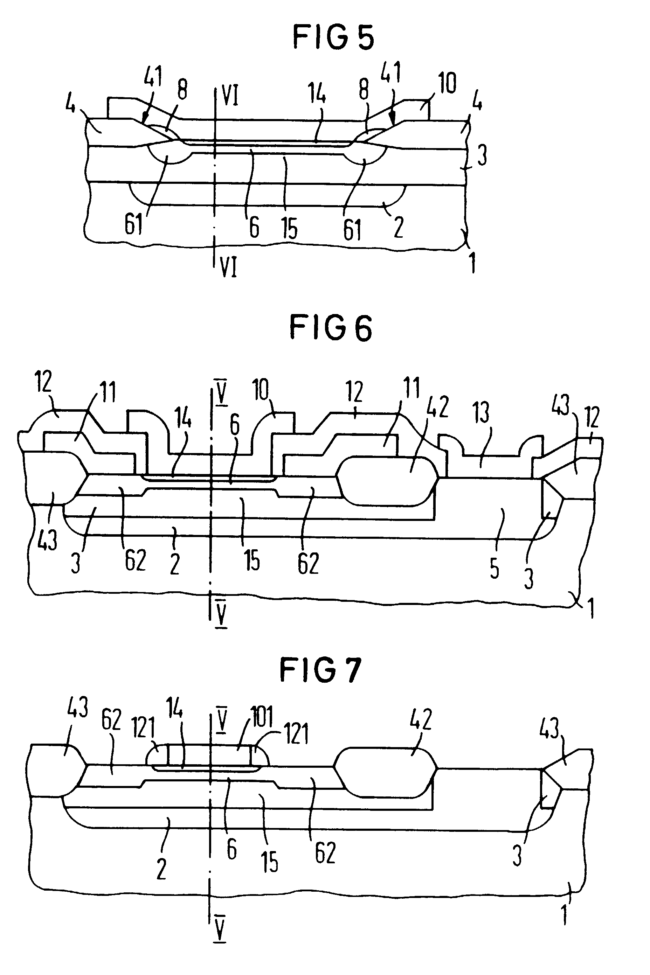

Nach Maskierung der übrigen Gebiete wird ein Kollektortiefanschluß 5 durch Ionenimplantation und anschließender Diffusion erzeugt (s. Fig. 6). Der Kollektortiefanschluß 5 ist seitlich des aktiven Transistorbereichs angeordnet. Er ist von dem aktiven Transistorbereich durch eine Isolationsstruktur 42 isoliert und reicht von der Oberfläche der Epitaxieschicht 3 auf die vergrabene Kollektorschicht 2.

Nach Maskierung der entsprechenden Bereiche wird durch Ionenimplantation mit z. B. Bor mit einer Energie von 15 keV und einer Dosis von 3 x 10⁻¹³ cm⁻² eine aktive Basis 6 innerhalb der Isolationsstruktur 4 erzeugt (s. Fig. 1).

Es folgt die ganzflächige, konforme Abscheidung einer Isolationsschicht 7 aus Bor-Silikat-Glas (s. Fig. 2). Die Abscheidung der Isolationsschicht 7 wird z. B. aus Borglas in einem Abscheiderohr durch Abscheidung aus der Gasphase bei niedrigem Druck (low pressure chemical vapour deposition, LPCVD) erzeugt. Dabei wird Tristrimethylsilylborat B(OSi(CH₃)₃)₃ unter Beigabe von O₂ in das Abscheiderohr geleitet.

Durch anisotropes Rückätzen z. B. mit CHF₃ werden an den Flanken 41 Flankenbedeckungen (Spacer) 8 erzeugt. Die Flankenbedeckungen 8 sind Bor-dotiert. Sie sind als Diffusionsquelle geeignet (s. Fig. 3).

Mit Hilfe einer Temperung bei z. B. 900 °C während z. B. 15 Minuten wird der Dotierstoff, Bor, aus den Flankenbedeckungen 8 ausdiffundiert. Dabei wird an den Flanken 41 benachbarten Rändern der aktiven Basis 6 die Dotierung lokal angehoben. Es kommt zur Ausbildung von Basisrandgebieten 61 (s. Fig. 4).

Anschließend wird in bekannter Weise ein Basisanschluß 11 (s. Fig. 6) erzeugt. Dazu wird eine p-dotierte Polysiliziumschicht abgeschieden und anschließend so strukturiert, daß die aktive Basis 6 über eine inaktive Basis 62 durch den Basisanschluß 11 seitlich angeschlossen wird. Der Basisanschluß 11 ist an denjenigen Seiten der Basis 6 angeordnet, an denen die aktive Basis 6 nicht durch die Isolationsstruktur 4 begrenzt ist. Der Basisanschluß 11 wird durch Abscheidung und Rückätzung einer Isolationsschicht 12 bedeckt. Die Isolationsschicht 12 läßt die Oberfläche der aktiven Basis 6 und des Kollektortiefanschlusses 5 unbedeckt.

Anschließend wird ganzflächig eine n-dotierte Polysiliziumschicht 9 abgeschieden (s. Fig. 4). Durch Strukturierung wird aus der n-dotierten Polysiliziumschicht 9 ein Emitteranschluß 10 gebildet (s. Fig. 5 und Fig. 6), der den Siliziumbereich überdeckt, der durch die Flankenbedeckungen 8 und die Isolationsschicht 12 begrenzt wird. Des weiteren wird aus der n-dotierten Polysiliziumschicht 9 bei der Strukturierung ein Kollektoranschluß 13 (s. Fig. 6) gebildet.

In einem Temperschritt bei z. B. 1050° C während 10 Sek. wird durch Ausdiffusion aus dem Emitteranschluß 10 ein Emitter 14 oberhalb der aktiven Basis 6 gebildet.

Kollektor 15 der Bipolartransistorstruktur (s. Fig. 5 und Fig. 6) bildet derjenige Teil der Epitaxieschicht 3, der unmittelbar unter der aktiven Basis 6 angeordnet ist. Der Kollektor 15 ist über die vergrabene Kollektorschicht 2 und den Kollektortiefanschluß 3 mit dem Kollektoranschluß 13 verbunden (s. Fig. 6). Die Basisrandgebiete 61 stellen sicher, daß ein Kurzschluß zwischen dem Emitter 14 und dem Kollektor 15 über den Rand der aktiven Basis 6 verhindert wird (s. Fig. 5).

Fig. 5 stellt den mit V-V in Fig. 6 bezeichneten Schnitt durch die Bipolartransistorstruktur dar. Fig. 6 stellt den mit VI-VI in Fig. 5 bezeichneten Schnitt durch die Bipolartransistorstruktur dar. Die in Fig. 6 dargestellte Bipolartransistorstruktur wird als Innenspacertransistor /PSA bezeichnet. In Fig. 6 ist mit dem Bezugszeichen 42 eine Isolationsstruktur bezeichnet, die den Kollektortiefanschluß 13 von den aktiven Transistorbereichen 6, 14, 15 trennt. Mit dem Bezugszeichen 43 wird eine Isolationsstruktur bezeichnet, die den Bipolartransistor im Substrat 1 und der Epitaxieschicht 3 gegenüber benachbarten Schaltelementen isoliert.

Das Herstellverfahren wird in bekannter Weise durch ganzflächiges Abscheiden einer Passivierungsschicht, Kontaktlochöffnung und -Metallisierung beendet.

In Fig. 7 ist eine weitere mögliche Ausführungsform der erfindungsgemäß hergestellten Bipolartransistorstruktur dargestellt. Sie unterscheidet sich von der in Fig. 6 dargestellten dadurch, daß ein Emitteranschluß 101 aus z. B. n-dotiertem Polysilizium seitlich von außen durch Flankenbedeckungen 121 begrenzt wird. Der Emitter 14 wird durch Ausdiffusion aus dem Emitteranschluß 101 erzeugt. Die inaktive Basis 62 wird z. B. durch Implantation zwischen den Isolationsstrukturen 42, 43 und den Flankenbedeckungen 121 so erzeugt, daß sie seitlich Kontakt zu der aktiven Basis 6 hat. Diese Bipolartransistorstruktur wird als Außenspacer-Transistor bezeichnet. Der in Fig. 7 mit V-V bezeichnete Schnitt ist identisch mit dem in Fig. 5 dargestellten.

## Patentansprüche

1. Verfahren zur Herstellung eines Bipolartransistors,
- bei dem auf eine Oberfläche eines Halbleitersubstrats (1) eine n-dotierte Epitaxieschicht (3) abgeschieden wird, wobei ein Teil der Epitaxieschicht (3) einen Kollektor (15) des Bipolartransistors bildet,
- bei dem an der Oberfläche der Epitaxieschicht (3) eine Isolationsstruktur (4) erzeugt wird, die einen aktiven Transistorbereich an mindestens einer Seite durch eine die Oberfläche der Epitaxieschicht (3) überragende Flanke (41) begrenzt, die nicht parallel zur Oberfläche der Epitaxieschicht (3) verläuft,
- bei dem durch Ionenimplantation von Bor innerhalb der Isolationsstruktur (4) eine aktive Basis (6) des Bipolartransistors erzeugt wird,
- bei dem nach der Erzeugung der aktiven Basis (6) eine Isolationsschicht (7) aus Borsilikatglas ganzflächig und konform abgeschieden wird,
- bei dem durch anisotropes Rückätzen aus der Isolationsschicht (7) eine Flankenbedeckung (8) gebildet wird, die an der den aktiven Transistorbereich begrenzenden Flanke der Isolationsstruktur (4) angeordnet ist, wobei eine Oberfläche der aktiven Basis (6) freigelegt wird,
- bei dem durch Ausdiffusion aus der Flankenbedeckung (8) ein Basisrandgebiet (61) erzeugt wird, das an einem der den aktiven Transistorbereich begrenzenden Flanke der Isolationsstruktur (4) benachbarten Rand der aktiven Basis (6) angeordnet ist, und das höher dotiert als der übrige Teil der Basis (6) ist,
- bei dem ein Basisanschluß (11) an einer Seite der Basis (6), an der die Basis (6) nicht durch die Flanke (41) begrenzt ist, gebildet wird,
- bei dem eine inaktive Basis (62) so erzeugt wird, daß die aktive Basis (6) über die inaktive Basis (62) durch den Basisanschluß (11) seitlich angeschlossen wird,
- bei dem ein n-dotierter Emitteranschluß (10), der einen Teil der Basis (6) überdeckt, welcher durch die Flankenbedeckung (8) begrenzt ist, und durch Ausdiffusion aus dem Emitteranschluß (10) ein Emitter (14) des Bipolartransistors oberhalb der aktiven Basis (6) gebildet werden.

2. Verfahren nach Anspruch 1, bei dem die Isolationsschicht (7) durch LPCVD-Abscheidung unter Verwendung von Tristrimethylsilylborat und O₂ erzeugt wird.

3. Verfahren nach Anspruch 2, bei dem das anisotrope Rückätzen zur Bildung der Flankenbedeckung (8) mit CHF₃ erfolgt.

4. Verfahren nach einem der Ansprüche 1 bis 3, bei dem der Emitteranschluß (10) durch ganzflächige Abscheidung und anschließende Strukturierung einer Polysiliziumschicht gebildet wird.

5. Verfahren nach einem der Ansprüche 1 bis 4,
- bei dem vor Abscheidung der Epitaxieschicht (3) eine im Substrat (1) vergrabene n-dotierte Kollektorschicht (2) gebildet wird,
- bei dem der Kollektor (15) an die vergrabene Kollektorschicht (2) angrenzt.

## Claims

1. Method for producing a bipolar transistor
- in which an n-doped epitaxial layer (3) is deposited onto a surface of a semiconductor substrate (1), part of the epitaxial layer (3) forming a collector (15) of the bipolar transistor,
- in which an insulation structure (4) is produced on the surface of the epitaxial layer (3) and bounds an active transistor area on at least one side by means of a flank (41) which overhangs the surface of the epitaxial layer (3) but does not run parallel to the surface of the epitaxial layer (3),
- in which an active base (6) of the bipolar transistor is produced by ion implantation of boron within the insulation structure (4),
- in which, after production of the active base (6), an insulation layer (7) composed of boron-silicate glass is deposited over the entire surface and conformerly,
- in which a flank cover (8) is formed by anisotropic etching back from the insulation layer (7) and is arranged on that flank of the insulation structure (4) which bounds the active transistor area, a surface of the active base (6) being exposed,
- in which a base edge region (61) is produced by diffusion out of the flank cover (8) and is arranged on an edge of the active base (6) adjacent to that flank of the insulation structure (4) which bounds the active transistor area, and which base edge region (6) is more highly doped than the remaining part of the base (6),
- in which a base connection (11) is formed on a side of the base (6) on which the base (6) is not bounded by the flank (41),
- in which an inactive base (62) is produced such that the active base (6) is connected at the side via the inactive base (62) by means of the base connection (11),
- in which an n-doped emitter connection (10), which covers a part of the base (6) which is bounded by the flank cover (8), is formed and an emitter (14) of the bipolar transistor above the active base (6) is formed by diffusion out of the emitter connection (10).

2. Method according to Claim 1, in which the insulation layer (7) is produced by LPCVD deposition, using tristrimethylsilylborate and O₂.

3. Method according to Claim 2, in which the anisotropic etching back to form the flank cover (8) is carried out using CHF₃.

4. Method according to one of Claims 1 to 3, in which the emitter connection (10) is formed by deposition over the entire surface, and subsequent structuring of a polysilicon layer.

5. Method according to one of Claims 1 to 4,
- in which, before deposition of the epitaxial layer (3), an n-doped collector layer (2) is formed which is buried in the substrate (1),
- in which the collector (15) is adjacent to the buried collector layer (2).

## Revendications

1. Procédé de fabrication d'un transistor bipolaire
- dans lequel on dépose sur une surface d'un substrat semi-conducteur (1), une couche épitaxiale (3) dopée de type n, une partie de la couche épitaxiale (3) formant un collecteur (15) du transistor bipolaire,
- dans lequel on crée à la surface de la couche épitaxiale (3) une structure d'isolation (4), qui limite une région active de transistor sur au moins un côté par un flanc (41) dépassant la surface de la couche épitaxiale (3), flanc qui n'est pas parallèle à la surface de la couche épitaxiale (3),
- dans lequel on crée une base active (6) du transistor bipolaire par implantation ionique de bore à l'intérieur de la structure d'isolation (4),
- dans lequel après la création de la base active (6), on dépose une couche d'isolation (7) en verre de borosilicate sur toute la surface et de manière conforme,
- dans lequel on forme par gravure anisotrope en retrait à partir de la couche d'isolation (7), un recouvrement de flanc (8), qui est disposé au flanc de la structure d'isolation (4) limitant la région active du transistor, en dégageant une surface de la base active (6),
- dans lequel on crée par exodiffusion à partir du recouvrement de flanc (8) une région de bord de la base (61), qui est disposée sur un bord de la base active (6) adjacent à un flanc de la structure d'isolation (4) limitant la région active du transistor, et qui est dopée d'une façon plus importante que le reste de la base (6),
- dans lequel une connexion de base (11) est formée sur un des côtés de la base (6) sur lequel la base (6) n'est pas limitée par le flanc (41),
- dans lequel une base inactive (62) est créée de telle manière que la base active (6) est raccordée latéralement via la base inactive (62) par la connexion de base (11),
- dans lequel on forme une connexion d'émetteur (10) dopée de type n qui recouvre une partie de la base (6), qui est limitée par le recouvrement de flanc (8) et un émetteur (14) du transistor bipolaire par exodiffusion à partir de la connexion d'émetteur (10) au-dessus de la base active (6).

2. Procédé selon la revendication 1, dans lequel la couche d'isolation (7) est réalisée par dépôt LPCVD en utilisant du tristriméthylsilylborate et du O₂.

3. Procédé selon la revendication 2, dans lequel la gravure anisotrope en retrait en vue de la formation du recouvrement de flanc (8) est effectuée au moyen de CHF₃.

4. Procédé selon l'une des revendications 1 à 3, dans lequel la connexion d'émetteur (10) est formée par un dépôt sur toute la surface et par structuration subséquente d'une couche de polysilicium.

5. Procédé selon l'une des revendications 1 à 4,
- dans lequel avant le dépôt de la couche épitaxiale (3), on forme dans le substrat (1) une couche de collecteur (2) enfouie, dopée de type n,
- dans lequel le collecteur (15) est contigu à la couche de collecteur enfouie (2).
